# EUROPEAN PATENT APPLICATION

(11) **EP 4 198 080 A1**
(43) Date of publication of application: **21.06.2023**
(21) Application number: 21855967.2
(22) Date of filing: 10.08.2021
(51) Int. Cl.: C08K 7/02, C08L 45/00, C08L 65/00, B65D 85/30, B65D 85/90

(54) **RESIN COMPOSITION AND METHOD FOR PRODUCING SAME, MOLDING MATERIAL, PACKAGING CONTAINER, AND SEMICONDUCTOR CONTAINER**

(30) Priority: 12.08.2020 JP 2020136485
(71) Applicant: Zeon Corporation, Tokyo 100-8246 (JP)
(72) Inventor: MIYAZAWA Shinsuke, Tokyo 100-8246 (JP)
(74) Representative: Maiwald GmbH
(86) International application number: PCT/JP2021/029572
(87) International publication number: WO 2022/034888

(57) **Abstract**

A resin composition contains: a resin including one or more among a norbornene-based polymer, a monocyclic cycloolefin-based polymer, a cyclic conjugated diene-based polymer, a vinyl alicyclic hydrocarbon polymer, and hydrogenated products thereof; and a conductive fibrous filler having an aspect ratio of not less than 5 and not more than 500.

## Description

### TECHNICAL FIELD

The present disclosure relates to a resin composition and method of producing the same and to a shaping material, packaging container, and semiconductor container that contain this resin composition.

### BACKGROUND

Alicyclic structure-containing polymers have been attracting interest in recent years as raw materials for various resin shaped products due to being capable of displaying various excellent physical properties such as heat resistance and mechanical strength. For example, Patent Literature (PTL) 1 discloses a resin composition containing 5 parts by weight to 100 parts by weight of whiskers having an aspect ratio of 2 to 100 and 5 parts to 20 parts of a white pigment relative to 100 parts by weight of a crystalline hydrogenated cycloolefin ring-opened polymer that includes repeating units derived from a polycyclic norbornene-based monomer including three or more rings. Through the resin composition according to PTL 1, it is possible to provide an LED optical reflector having excellent heat resistance and optical reflectance. As another example, PTL 2 discloses a conductive polymer film that contains a polymer component including 10 mass% to 100 mass% of a hydrogenated product of an aromatic vinyl-conjugated diene block copolymer, carbon fiber, and a conductive filler other than carbon fiber and in which the proportional contents of the carbon fiber and the conductive filler other than carbon fiber are within specific ranges. The conductive polymer film according to PTL 2 can suitably be used in production of a current collector of an electric double-layer capacitor due to having low volume resistivity and high mechanical strength. As a further example, PTL 3 discloses a resin composition that contains a cycloolefin homopolymer having a glass-transition temperature within a specific range, a fibrous conductive filler, and an elastomer and in which the content of the elastomer is within a specific range. The resin composition according to PTL 3 has excellent mechanical strength, heat resistance, electrical conductivity, and low outgassing when made into a shaped product.

### CITATION LIST

### Patent Literature

PTL 1: JP2015-178580A
PTL 2: JP2011-68747A
PTL 3: JP2013-231171A

### SUMMARY

### (Technical Problem)

In recent years, there has been demand for resin compositions that contain conductive fillers to have a low tendency for particle detachment to occur due to the conductive filler and like and to have excellent cleanliness when a shaped item is produced therewith. It is also necessary for shaped items formed using conductive filler-containing resin compositions to have excellent electrical conductivity. However, the resin compositions according to the conventional techniques described above have not enabled a balance of high levels of electrical conductivity and cleanliness in an obtained shaped item.

Accordingly, one object of the present disclosure is to provide a resin composition that enables a balance of high levels of electrical conductivity and cleanliness in an obtained shaped item and a method of producing this resin composition. Another object of the present disclosure is to provide a shaping material, a packaging container, and a semiconductor container that can display a balance of high levels of electrical conductivity and cleanliness.

### (Solution to Problem)

The present disclosure aims to advantageously solve the problem set forth above, and a presently disclosed resin composition contains: a resin including one or more among a norbornene-based polymer, a monocyclic cycloolefin-based polymer, a cyclic conjugated diene-based polymer, a vinyl alicyclic hydrocarbon polymer, and hydrogenated products thereof; and a conductive fibrous filler having an aspect ratio of not less than 5 and not more than 500. When a resin composition contains a specific resin and a conductive fibrous filler having an aspect ratio of not less than 5 and not more than 500 in this manner, this enables a balance of high levels of electrical conductivity and cleanliness in an obtained shaped item.

Note that the "aspect ratio" of a conductive fibrous filler can be measured by a method described in the EXAMPLES section of the present specification.

In the presently disclosed resin composition, an amount of the conductive fibrous filler is preferably not less than 30 parts by mass and not more than 240 parts by mass relative to 100 parts by mass of the resin. When the amount of the conductive fibrous filler relative to 100 parts by mass of the resin satisfies the range set forth above, electrical conductivity and cleanliness of an obtained shaped item can be increased in a good balance.

In the presently disclosed resin composition, the resin preferably includes a crystalline resin. When the resin includes a crystalline resin, electrical conductivity of an obtained shaped item can be further increased, and mechanical strength of the shaped item can also be increased.

Note that when a resin is referred to as "crystalline", this means that a melting point is detected through measurement by differential scanning calorimetry (DSC) in accordance with JIS K7121. Also note that "crystallinity" of a resin is an attribute characteristic of a polymer having a certain specific structure and can arise due to polymer chains of a constituent polymer of the resin having stereoregularity.

In the presently disclosed resin composition, the resin preferably includes a ring-opened polymer of a monomer having a norbornene structure or a hydrogenated product thereof. When the resin composition contains a ring-opened polymer of a monomer having a norbornene structure or a hydrogenated product thereof, outgassing from an obtained shaped item can be reduced.

Moreover, the present disclosure aims to advantageously solve the problem set forth above, and a presently disclosed shaping material comprises any one of the resin compositions set forth above. When a shaping material contains the presently disclosed resin composition, this enables a balance of high levels of electrical conductivity and cleanliness in an obtained shaped item.

Furthermore, the present disclosure aims to advantageously solve the problem set forth above, and a presently disclosed packaging container and semiconductor container are obtained through shaping of any one of the resin compositions set forth above. When a packaging container or semiconductor container is obtained through shaping of the presently disclosed resin composition, the packaging container or semiconductor container has excellent electrical conductivity and cleanliness.

Also, the present disclosure aims to advantageously solve the problem set forth above, and a presently disclosed method of producing a resin composition comprises a mixing step of mixing the resin and a conductive fibrous filler ingredient having an aspect ratio of not less than 17 and not more than 500 to obtain a mixture of the resin and a conductive fibrous filler having an aspect ratio of not less than 5 and not more than 500. The presently disclosed method of producing a resin composition set forth above enables efficient production of the presently disclosed resin composition.

### (Advantageous Effect)

According to the present disclosure, it is possible to provide a resin composition that enables a balance of high levels of electrical conductivity and cleanliness in an obtained shaped item and a method of producing this resin composition.

Moreover, according to the present disclosure, it is possible to provide a shaping material, a packaging container, and a semiconductor container that can display a balance of high levels of electrical conductivity and cleanliness.

### DETAILED DESCRIPTION

The following provides a detailed description of embodiments of the present disclosure. The presently disclosed resin composition can be used to produce the presently disclosed shaping material, packaging container, and semiconductor container. Moreover, the presently disclosed resin composition can be efficiently produced by the presently disclosed method of producing a resin composition.

### (Resin composition)

A feature of the presently disclosed resin composition is that it contains: a resin including one or more among a norbornene-based polymer, a monocyclic cycloolefin-based polymer, a cyclic conjugated diene-based polymer, a vinyl alicyclic hydrocarbon polymer, and hydrogenated products thereof; and a conductive fibrous filler having an aspect ratio of not less than 5 and not more than 500. The presently disclosed resin composition enables a balance of high levels of electrical conductivity and cleanliness in an obtained shaped item as a result of containing a specific resin and a conductive fibrous filler that has an aspect ratio of not less than 5 and not more than 500.

### <Resin>

The resin that is contained in the presently disclosed resin composition includes one or more among a norbornene-based polymer, a monocyclic cycloolefin-based polymer, a cyclic conjugated diene-based polymer, a vinyl alicyclic hydrocarbon polymer, and hydrogenated products thereof. These resins are preferably not crosslinked.

The norbornene-based polymer or hydrogenated product thereof may, for example, be a ring-opened polymer of a monomer having a norbornene structure or a hydrogenated product thereof; or an addition polymer of a monomer having a norbornene structure or a hydrogenated product thereof. Moreover, the ring-opened polymer of a monomer having a norbornene structure may, for example, be a ring-opened homopolymer of one monomer having a norbornene structure, a ring-opened copolymer of two or more monomers each having a norbornene structure, or a ring-opened copolymer of a monomer having a norbornene structure and any monomer that is copolymerizable therewith. Furthermore, the addition polymer of a monomer having a norbornene structure may be an addition homopolymer of one monomer having a norbornene structure, an addition copolymer of two or more monomers each having a norbornene structure, or an addition copolymer of a monomer having a norbornene structure and any monomer that is copolymerizable therewith. More specifically, the ring-opened polymer of a monomer having a norbornene structure may be a polymer that is obtained through ring-opening polymerization of a norbornene-based monomer disclosed in JP2002-321302A, such as an optionally substituted norbornene or an optionally substituted dicyclopentadiene. Moreover, the addition polymer of a monomer having a norbornene structure may, for example, be a copolymer obtained through addition polymerization of ethylene with a norbornene-based monomer, and, more specifically, may be a random copolymer of a dicyclopentadiene derivative and ethylene.

The monocyclic cycloolefin-based polymer may, for example, be an addition polymer of a monocyclic cycloolefin-based monomer such as cyclobutene, cyclopentene, cyclohexene, cycloheptene, or cyclooctene.

The cyclic conjugated diene-based polymer may, for example, be a polymer obtained through 1,2-addition polymerization or 1,4-addition polymerization of a cyclic conjugated diene-based monomer such as cyclopentadiene or cyclohexadiene, or a derivative of any of these monomers, or may be a hydrogenated product of such a polymer.

The vinyl alicyclic hydrocarbon polymer may, for example, be a polymer of a vinyl alicyclic hydrocarbon-based monomer such as vinylcyclohexene or vinylcyclohexane or a hydrogenated product thereof, or may be a product resulting from hydrogenation of an aromatic ring part of a polymer of a vinyl aromatic-based monomer such as styrene, α-methylstyrene, p-methylstyrene, t-butylstyrene, or vinylnaphthalene. In this case, a copolymer (random copolymer, block copolymer, etc.) of a vinyl alicyclic hydrocarbon monomer or vinyl aromatic-based monomer with another monomer that is copolymerizable therewith, or a hydrogenated product thereof may be used. The block copolymer may be a diblock copolymer, a triblock copolymer, a multiblock copolymer with even more blocks, a gradient block copolymer, or the like without any specific limitations.

In particular, it is preferable that the resin includes a crystalline resin. When the resin includes a crystalline resin, electrical conductivity of an obtained shaped item can be further increased, and mechanical strength of the shaped item can also be increased. In a case in which the resin includes a crystalline resin, the proportion constituted by the crystalline resin in the overall resin is preferably 50 mass% or more, and may be 100 mass%.

Moreover, the resin preferably includes a ring-opened polymer of a monomer having a norbornene structure or a hydrogenated product thereof. When the resin includes a ring-opened polymer of a monomer having a norbornene structure or a hydrogenated product thereof, outgassing from an obtained shaped item can be reduced. In a case in which the resin includes a ring-opened polymer of a monomer having a norbornene structure or a hydrogenated product thereof, the total content of the ring-opened polymer of a monomer having a norbornene structure and hydrogenated product thereof in the overall resin is preferably 50 mass% or more, and may be 100 mass%.

In addition to units derived from a monomer having a norbornene structure, the ring-opened polymer of a monomer having a norbornene structure or hydrogenated product thereof may also include units derived from other monomers that can be ring-opening copolymerized with these units. Examples of such monomers include monocyclic cycloolefin-based monomers such as cyclohexene, cycloheptene, and cyclooctene. One of these other monomers that can be ring-opening copolymerized with a monomer having a norbornene structure may be used individually, or two or more thereof may be used in combination. The proportion constituted by units derived from a monomer having a norbornene structure in the ring-opened polymer of a monomer having a norbornene structure or hydrogenated product thereof is preferably 70 mass% or more, more preferably 80 mass% or more, and even more preferably 90 mass% or more, and may be 100 mass%.

Furthermore, it is preferable that the resin includes a hydrogenated product of a ring-opened polymer of a monomer having a norbornene structure. The hydrogenation rate of this hydrogenated product (i.e., the proportion of unsaturated bonds that have been hydrogenated through a hydrogenation reaction) is not specifically limited but is preferably 98% or more, and more preferably 99% or more based on all unsaturated bonds included in the main chain and side chains of the polymer. A higher hydrogenation rate results in the resin having better heat resistance.

A preferable example of the ring-opened polymer of a monomer having a norbornene structure or hydrogenated product thereof is a ring-opened polymer that includes monomer units derived from a dicyclopentadiene or a hydrogenated product of this polymer (hereinafter, also referred to simply as a "dicyclopentadiene-based ring-opened polymer or hydrogenated product thereof'). These polymers may also include units derived from other monomers that can be ring-opening copolymerized with the dicyclopentadiene.

Examples of optionally substituted dicyclopentadienes that can be used in production of the dicyclopentadiene-based ring-opened polymer or hydrogenated product thereof include dicyclopentadiene, methyldicyclopentadiene, and 5,6-dihydrodicyclopentadiene. Moreover, examples of other monomers that can be used in production of the dicyclopentadiene-based ring-opened polymer or hydrogenated product thereof include, but are not specifically limited to, norbornenes other than dicyclopentadienes such as 7,8-benzotricyclo[4.3.0.1^{2,5}]dec-3-ene (common name: methanotetrahydrofluorene; also referred to as 1,4-methano-1,4,4a,9a-tetrahydrofluorene) and derivatives thereof, tetracyclo[4.4.0.1^{2,5}.1^{7,10}]dodec-3-ene (common name: tetracyclododecene) and derivatives thereof, and so forth; cycloolefins; and dienes. No specific limitations are placed on the proportional content of the optionally substituted dicyclopentadiene in the dicyclopentadiene-based ring-opened polymer or hydrogenated product thereof. The norbornene-based polymer can be produced according to a standard method (for example, refer to WO2018/174029A1). Moreover, the dicyclopentadiene-based ring-opened polymer or hydrogenated product thereof is preferably crystalline.

In particular, it is preferable that the dicyclopentadiene-based ring-opened polymer or hydrogenated product thereof has syndiotactic stereoregularity. The proportional content of monomer units derived from the dicyclopentadiene in the dicyclopentadiene-based ring-opened polymer or hydrogenated product thereof when the overall polymer is taken to be 100 mass% is preferably more than 90 mass%, and more preferably more than 95 mass%.

The method by which the dicyclopentadiene-based ring-opened polymer or hydrogenated product thereof is produced is not specifically limited and may, for example, be a known method in which monomers such as described above are ring-opening polymerized using a metathesis polymerization catalyst. Examples of such methods include a method described in JP2017-149898A.

The weight-average molecular weight (Mw) of the dicyclopentadiene-based ring-opened polymer is not specifically limited but is normally 1,000 to 1,000,000, and preferably 2,000 to 500,000. By subjecting a ring-opened polymer having a weight-average molecular weight such as set forth above to a hydrogenation reaction, it is possible to obtain a hydrogenated dicyclopentadiene-based ring-opened polymer excelling in terms of shaping processability and the like. Note that the weight-average molecular weight of the dicyclopentadiene-based ring-opened polymer can be adjusted by adjusting the additive amount of a molecular weight modifier that is used in polymerization, for example.

The molecular weight distribution (Mw/Mn) of the dicyclopentadiene-based ring-opened polymer is not specifically limited but is normally 1.0 to 4.0, and preferably 1.5 to 3.5. By subjecting a dicyclopentadiene-based ring-opened polymer having a molecular weight distribution such as set forth above to a hydrogenation reaction, it is possible to obtain a hydrogenated dicyclopentadiene-based ring-opened polymer excelling in terms of shaping processability and the like. Note that the molecular weight distribution of the dicyclopentadiene-based ring-opened polymer can be adjusted through the addition method and concentration of monomers in the polymerization reaction.

The weight-average molecular weight (Mw) and molecular weight distribution (Mw/Mn) of the dicyclopentadiene-based ring-opened polymer are polystyrene-equivalent values measured by gel permeation chromatography (GPC) with tetrahydrofuran as an eluent solvent.

The dicyclopentadiene-based ring-opened polymer or hydrogenated product thereof is preferably a hydrogenated dicyclopentadiene-based ring-opened polymer (hereinafter, also referred to as "polymer (α1)").

The melting point of the polymer (α1) is preferably 200°C or higher, and more preferably 220°C or higher, and is preferably 350°C or lower, more preferably 320°C or lower, and even more preferably 300°C or lower. A resin composition containing a polymer (α1) that has a melting point within any of the ranges set forth above has good formability.

The degree of stereoregularity of the polymer (α1) in terms of the proportion of racemo diads is preferably 51% or more, more preferably 60% or more, particularly preferably 65% or more, and most preferably 70% or more, and is preferably 100% or less, more preferably less than 95%, and particularly preferably 90% or less. A higher proportion of racemo diads and thus a higher degree of syndiotactic stereoregularity results in the polymer (α1) having a higher melting point. Moreover, producibility of the polymer (α1) can be increased when the proportion of racemo diads is less than or not more than any of the upper limits set forth above. Note that the proportion of racemo diads can be determined based on ¹³C-NMR measurement described in the EXAMPLES section of the present specification.

### <Conductive fibrous filler>

The conductive fibrous filler that is contained in the presently disclosed resin composition is required to have an aspect ratio of not less than 5 and not more than 500. The aspect ratio of the conductive filler is preferably 7 or more, and more preferably 10 or more, and is preferably 400 or less, more preferably 300 or less, even more preferably 200 or less, and particularly preferably 100 or less. When the aspect ratio of the conductive fibrous filler is not less than any of the lower limits set forth above, electrical conductivity of an obtained shaped item can be further increased because a good electrical conduction network can be formed among the conductive fibrous filler in the shaped item. Moreover, when the aspect ratio of the conductive fibrous filler is not more than any of the upper limits set forth above, cleanliness of an obtained shaped item can be further increased because the conductive fibrous filler has a lower tendency to detach from the shaped item.

The conductive fibrous filler can be any conductive fibrous filler without any specific limitations so long as the aspect ratio thereof satisfies any of the ranges set forth above. For example, the conductive fibrous filler may be carbon fiber such as PAN-based carbon fiber (PAN: polyacrylonitrile) or pitch-based carbon fiber; metal oxide fiber of tin oxide, indium oxide, alumina, zinc oxide, or the like; or metal fiber of steel, stainless steel, tungsten, copper, or the like. Of these examples, pitch-based carbon fiber and metal oxide fiber are preferable. Although the pitch-based carbon fiber may be isotropic pitch-based carbon fiber or mesophase pitch-based carbon fiber, the use of isotropic pitch-based carbon fiber is appropriate.

### <Amount of conductive fibrous filler>

The amount of the conductive fibrous filler in the resin composition relative to 100 parts by mass of the resin is preferably 30 parts by mass or more, and more preferably 40 parts by mass or more, and is preferably 240 parts by mass or less, more preferably 200 parts by mass or less, even more preferably 100 parts by mass or less, and particularly preferably 70 parts by mass or less. When the amount of the conductive fibrous filler is not less than any of the lower limits set forth above, electrical conductivity and strength of an obtained shaped item can be increased. When the amount of the conductive fibrous filler is not more than any of the upper limits set forth above, cleanliness of an obtained shaped item can be further increased because the amount of the conductive fibrous filler that detaches from the shaped item can be reduced.

### <Other components>

The presently disclosed resin composition may optionally contain other components such as additives. Examples of additives include antioxidants, crystal nucleating agents, waxes, ultraviolet absorbers, light stabilizers, near-infrared absorbers, colorants such as dyes and pigments, plasticizers, antistatic agents, and fluorescent whitening agents. The content of these additives can be set as appropriate depending on the aim.

### (Production method of resin composition)

The resin composition can be produced by mixing the above-described resin, conductive fibrous filler, and optionally used additives. The mixing method is not specifically limited and may, for example, be a method in which melt-kneading is performed using a single-screw kneader, a twin-screw kneader, or the like, or a method in which dry blending is performed using a mixer or the like. A solvent in which the resin can dissolve may be used as necessary in the mixing.

More specifically, it is preferable that in mixing of the resin and a conductive fibrous filler serving as an ingredient (hereinafter, also referred to as a "conductive fibrous filler ingredient"), the resin and a conductive fibrous filler ingredient having an aspect ratio of not less than 17 and not more than 500 are mixed to obtain a mixture of the resin and a conductive fibrous filler having an aspect ratio of not less than 5 and not more than 500. By using a material having an aspect ratio within the range set forth above as a conductive fibrous filler ingredient, by controlling mixing conditions (mixing temperature, rotation speed, etc.) in mixing of the resin therewith, and by controlling the aspect ratio of a conductive fibrous filler in the resultant mixture to within the specific range set forth above, it is possible to efficiently produce the presently disclosed resin composition.

Moreover, when the aspect ratio of the conductive fibrous filler ingredient (i.e., the pre-mixing aspect ratio) is taken to be A1 and the aspect ratio of the conductive fibrous filler (i.e., the post-mixing aspect ratio) is taken to be A2, the degree of aspect ratio preservation (A2/A1) between before and after mixing is preferably 0.60 or more, and more preferably 0.70 or more. By performing mixing under conditions such that the value of A2/A1 is not less than any of the lower limits set forth above, it is possible to inhibit degradation of the conductive fibrous filler ingredient in a production process of the resin composition and to extend the lifespan of the obtained resin composition, shaping material thereof, etc. Note that although no specific limitations are placed on an upper limit for the degree of aspect ratio preservation, the degree of aspect ratio preservation is normally 1.00 or less.

### (Shaping material)

A feature of the presently disclosed shaping material is that it contains the presently disclosed resin composition set forth above. The presently disclosed shaping material can display a balance of high levels of electrical conductivity and cleanliness as a result of containing the presently disclosed resin composition. Although no specific limitations are placed on the form of the shaping material, the shaping material may be a sheet-shaped material or a plate-shaped material, for example. When the shaping material is a sheet-shaped material or a plate-shaped material, the shaping material can suitably be subjected to press forming and can suitably be used to provide a shaped item having excellent electrical conductivity and cleanliness.

### (Packaging container)

A feature of the presently disclosed packaging container is that it contains the presently disclosed resin composition set forth above. The presently disclosed packaging container can display a balance of high levels of electrical conductivity and cleanliness as a result of containing the presently disclosed resin composition. Therefore, the presently disclosed packaging container is suitable as a packaging container for an electronic device component. The presently disclosed packaging container can be produced by shaping the presently disclosed resin composition or the presently disclosed shaping material by a shaping method that is appropriate for the target shape.

### (Semiconductor container)

A feature of the presently disclosed semiconductor container is that it contains the presently disclosed resin composition set forth above. The presently disclosed semiconductor container can display a balance of high levels of electrical conductivity and cleanliness as a result of containing the presently disclosed resin composition. The semiconductor container may, for example, be a front opening unified pod (FOUP), a front opening shipping box (FOSB), a wafer tray, or a wafer carrier used in a production process of a semiconductor, or may be a handle, carrier tape, dicing tape, wafer cassette, housing, or the like that can be attached to and used with any of these trays or carriers. The presently disclosed semiconductor container can be produced by shaping the presently disclosed resin composition or the presently disclosed shaping material by a shaping method that is appropriate for the target semiconductor container shape. More specifically, the semiconductor container can be shaped by a melt-shaping method, for example. Examples of melt-shaping methods include injection molding, blow molding, and injection blow molding. These methods can be selected as appropriate depending on the target container shape and the like. Of these methods, injection molding is preferable.

### EXAMPLES

The following provides a more specific description of the present disclosure based on examples. However, the present disclosure is not limited to the following examples. In the following description, "%" and "parts" used in expressing quantities are by mass, unless otherwise specified. Moreover, in the case of a polymer that is produced through copolymerization of a plurality of types of monomers, the proportion in the polymer constituted by a monomer unit that is formed through polymerization of a given monomer is normally, unless otherwise specified, the same as the ratio (charging ratio) of the given monomer among all monomers used in polymerization of the polymer.

Measurements of various physical properties in the examples and comparative examples were performed according to the following methods.

### (Aspect ratio of conductive fibrous filler ingredient (pre-mixing aspect ratio))

A used conductive filler ingredient was sampled to obtain a measurement sample, the surface of the measurement sample was observed using a microscope (Digital Microscope VHX-5000 produced by Keyence Corporation), and the aspect ratio of confirmed fibrous filler was calculated by dividing the major axis thereof by the minor axis thereof. The number of observed samples was set as 3, and an average value of aspect ratios determined for three randomly selected samples was taken to be the "aspect ratio of the conductive fibrous filler ingredient". The "major axis" of the fibrous filler ingredient was taken to be the diameter of a circle set such as to circumscribe the fibrous filler ingredient.

### (Aspect ratio of conductive fibrous filler (post-mixing aspect ratio))

A resin composition produced in each example or comparative example was dried at 120°C for 4 hours to obtain a dry resin composition. The obtained dry resin composition was loaded into a small-size injection molding machine (Micro Injection Moulding Machine 10cc produced by DSM Xplore), and then a shaped item of 30 mm × 60 mm × 3 mm (thickness) was produced by injection molding under conditions of a molding temperature of 290°C, an injection pressure of 0.7 MPa, and a mold temperature of 80°C. The surface of the shaped item that was obtained was observed using a microscope (Digital Microscope VHX-5000 produced by Keyence Corporation), and the aspect ratio of confirmed fibrous filler was calculated by dividing the major axis thereof by the minor axis thereof. The number of observed samples was set as 3, and an average value of aspect ratios determined for three randomly selected samples was taken to be the "aspect ratio of the conductive fibrous filler". Note that the aspect ratio of the conductive fibrous filler at a stage before formation of the shaped item (i.e., in the (dry) resin composition) and the aspect ratio of the conductive fibrous filler in the shaped item that undergoes surface observation can be substantially the same. Moreover, the "major axis" of the fibrous filler was taken to be the diameter of a circle set such as to circumscribe the fibrous filler.

### (Molecular weight of ring-opened polymer)

Ring-opened polymers produced in Examples 1 to 5, Examples 7 to 9, and Comparative Examples 1 to 3 were each used as a measurement sample. The obtained measurement sample was used to determine the molecular weight (weight-average molecular weight and number-average molecular weight) of the ring-opened polymer as a polystyrene-equivalent value using a Gel Permeation Chromatography (GPC) System HLC-8320 (produced by Tosoh Corporation) with an H-type column (produced by Tosoh Corporation) and tetrahydrofuran as a solvent at a temperature of 40°C.

### (Hydrogenation rate of hydrogenated ring-opened polymer)

The hydrogenation rate when ring-opened polymers produced in Examples 1 to 5, Examples 7 to 9, and Comparative Examples 1 to 3 were hydrogenated was measured by ¹H-NMR with orthodichlorobenzene-d₄ as a solvent.

### (Glass-transition temperature and melting point of hydrogenated ring-opened polymer)

Hydrogenated ring-opened polymers produced in Examples 1 to 5, Examples 7 to 9, and Comparative Examples 1 to 3 were each used as a measurement sample. The obtained measurement sample was heated to 320°C in a nitrogen atmosphere and was then rapidly cooled to room temperature at a cooling rate of -10°C/min using liquid nitrogen. The measurement sample was then heated at 10°C/min using a differential scanning calorimeter (DSC), and the glass-transition temperature and melting point of the hydrogenated ring-opened polymer were determined.

### (Proportion of racemo diads in hydrogenated ring-opened polymer)

Hydrogenated ring-opened polymers produced in Examples 1 to 5, Examples 7 to 9, and Comparative Examples 1 to 3 were each used as a measurement sample. The proportion of racemo diads was determined by performing ¹³C-NMR measurement by an inverse-gated decoupling method at 200°C with orthodichlorobenzene-d₄/TCB-d₃ (TCB: 1,2,4-trichlorobenzene) having a mixing ratio of 1/2 (by mass) as a solvent. Specifically, the proportion of racemo diads was determined based on an intensity ratio of a signal at 43.35 ppm attributed to meso diads and a signal at 43.43 ppm attributed to racemo diads with a peak at 127.5 ppm for orthodichlorobenzene-d₄ as a standard shift.

### (Cleanliness)

The cleanliness of shaped items obtained using resin compositions that were obtained in the examples and comparative examples was evaluated through the amount of particles. The surface of a shaped item obtained by the method described in the "Aspect ratio of conductive fibrous filler" section was washed with ultrapure water. The shaped item that had been washed was then left in a class 10,000 cleanroom for 168 hours. Thereafter, the surface of the shaped item was washed with ultrapure water, and the amount of particles in the washing water was measured by a particle counter.

The shaped item was judged to be clean in a case in which the amount of particles was 10,000 particles/mL or less.

### (Electrical conductivity)

The electrical conductivity of shaped items obtained using resin compositions that were obtained in the examples and comparative examples was evaluated through the surface resistivity of the shaped item. A resin composition obtained in each example or comparative example was dried at 120°C for 4 hours to obtain a dry resin composition. The obtained dry resin composition was loaded into an injection molding machine (S-2000i produced by FANUC), and a disk-like shaped item of 50 mm in diameter and 3 mm in thickness was produced through injection molding under conditions of a molding temperature of 290°C and a mold temperature of 80°C. The surface resistivity of the shaped item obtained in this manner was measured by an insulation meter (R-503 produced by Kawaguchi Electric Works).

Electrical conductivity was evaluated as excellent in a case in which the surface resistivity was 1 × 10¹⁰ Ω or less. Note that the lower limit for the measurement value of surface resistivity is not specifically limited and can be 1 × 10² Ω, for example.

### (Amount of outgas)

A resin composition produced in each example or comparative example was dried at 120°C for 4 hours to obtain a dry resin composition. The obtained dry composition was loaded into a sample container made of a glass tube having an internal diameter of 4 mm, this sample container was connected to a gas collection tube that was cooled by liquid nitrogen, and then the sample container was heated to 180°C for 30 minutes in a stream of high-purity helium (helium purity: 99.99995 volume% or higher), and gas released from the sample was continuously collected in the gas collection tube. The collected gas was subjected to thermal desorption-gas chromatography-mass spectrometry using n-decane as an internal standard, and the amount of gas released from the sample was calculated as an n-decane-equivalent value. The amount of outgas was judged to be sufficiently small in a case in which the amount of outgas was 50 ppm or less.

This analysis was performed using the following apparatus and analysis conditions.

### [Thermal desorption]

Apparatus: TDS A2 produced by Gerstel, Inc.
Sample heating conditions: 180°C, 30 minutes
Helium gas flow rate: 30 mL/min
Gas collection tube: Tube of 1 mm in diameter packed with glass wool
Temperature of gas collection tube: -130°C (during gas collection), 280°C (during gas release)

### [Gas chromatography]

Apparatus: 6890N produced by Agilent Technologies, Inc.
Column: HP-5ms (0.25 × 30 m, df = 0.25 µm) produced by Agilent Technologies, Inc.
Carrier gas flow rate: 1 mL/min
Column pressure: NONE (Flow control)
Heating profile: Holding at 40°C for 3 minutes, followed by heating to 280°C at heating rate of 10°C/min and holding at 280°C for 10 minutes

### [Mass spectrometer]

Apparatus: 5973N produced by Agilent Technologies, Inc.

### (Strength)

The strength of shaped items obtained using resin compositions that were obtained in the examples and comparative examples was evaluated through the flexural elastic modulus of the shaped item. A resin composition obtained in each example or comparative example was dried at 120°C for 4 hours to obtain a dry resin composition. The obtained dry resin composition was loaded into a small-size injection molding machine (Micro Injection Moulding Machine 10cc produced by DSM Xplore), and then a test specimen for flexural elastic modulus measurement of 80 mm × 10 mm × 4 mm (thickness) was produced by injection molding under conditions of a molding temperature of 290°C, an injection pressure of 0.7 MPa, and a mold temperature of 80°C. The obtained test specimen was then used to perform a flexural test in accordance with JIS K7171 at a testing rate of 2 mm/min using an Autograph (product name: AGS-5kNJ TCR2; produced by Shimadzu Corporation) in order to measure the flexural elastic modulus.

The strength was judged to be sufficiently high in a case in which the value of the flexural elastic modulus was 100 MPa or more.

### (Example 1)

### <Production of crystalline hydrogenated norbornene-based ring-opened polymer>

A metal pressure-resistant reactor that had been internally purged with nitrogen was charged with 154.5 parts of cyclohexane as an organic solvent, 42.8 parts (30 parts in terms of dicyclopentadiene) of a cyclohexane solution (concentration: 70%) of dicyclopentadiene (endo isomer content: 99% or more), and 1.9 parts of 1-hexene as a molecular weight modifier, and all contents thereof were heated to 53°C. Meanwhile, 0.014 parts of tetrachlorotungsten phenylimide (tetrahydrofuran) complex (metal compound) as a ring-opening polymerization catalyst was dissolved in 0.70 parts of toluene (organic solvent), and then 0.061 parts of an n-hexane solution (concentration: 19%) of diethylaluminum ethoxide (organometallic reducing agent) as a ring-opening polymerization catalyst was added to the resultant solution and was stirred therewith for 10 minutes to produce a ring-opening polymerization catalyst solution. The ring-opening polymerization catalyst solution was added into the aforementioned reactor, and a ring-opening polymerization reaction was carried out at 53°C for 4 hours to yield a solution containing a dicyclopentadiene ring-opened polymer.

The polymerization reaction was stopped by adding 0.037 parts of 1,2-ethanediol as an inhibitor to 200 parts of the obtained solution containing the dicyclopentadiene ring-opened polymer and performing stirring thereof at 60°C for 1 hour. Thereafter, 1 part of a hydrotalcite-like compound (product name: KYOWAAD^{®} 2000 (KYOWAAD is a registered trademark in Japan, other countries, or both); produced by Kyowa Chemical Industry Co., Ltd.) was added as an adsorbent, heating was performed to 60°C, and stirring was performed for 1 hour. Next, 0.4 parts of a filter aid (product name: Radiolite^{®} #1500 (Radiolite is a registered trademark in Japan, other countries, or both); produced by Showa Chemical Industry Co., Ltd.) was added, and the adsorbent was filtered off using a PP pleated cartridge filter (product name: TCP-HX; produced by Advantec Toyo Kaisha, Ltd.) to obtain a solution containing the dicyclopentadiene ring-opened polymer.

Upon measuring the molecular weight of the dicyclopentadiene ring-opened polymer using a portion of this solution, the weight-average molecular weight (Mw) was 28,100, the number-average molecular weight (Mn) was 8,750, and the molecular weight distribution (Mw/Mn) was 3.21.

Next, 100 parts of cyclohexane and 0.0043 parts of chlorohydridocarbonyltris(triphenylphosphine)ruthenium were added to 200 parts of the obtained solution containing the dicyclopentadiene ring-opened polymer (polymer content: 30 parts), and a hydrogenation reaction was carried out at 180°C and a hydrogen pressure of 6 MPa for 4 hours. The reaction liquid was a slurry in which solid content had precipitated.

Solid content and solution were separated through centrifugal separation of the reaction liquid, and then the solid content was dried under reduced pressure at 60°C for 24 hours to yield 28.5 parts of a hydrogenated dicyclopentadiene ring-opened polymer.

The hydrogenation rate of unsaturated bonds in the hydrogenation reaction was 99% or more. Moreover, the hydrogenated dicyclopentadiene ring-opened polymer had a glass-transition temperature of 98°C and a melting point of 262°C. Furthermore, the proportion of racemo diads was 89%.

A mixture was obtained by adding 42 parts of isotropic pitch-based carbon fiber (DONACARBO Milled S-C-2415 produced by Osaka Gas Chemicals Co., Ltd.; fiber diameter: 13 µm; fiber length: 0.22 mm) having an aspect ratio A1 of 17 as a conductive fibrous filler ingredient to 100 parts of pellets formed of the crystalline hydrogenated norbornene-based ring-opened polymer obtained as described above. This mixture was kneaded at a resin temperature of 280°C and a screw rotation speed of 100 rpm using a twin-screw extruder (TEM35B produced by Toshiba Machine Co., Ltd.), was extruded as strands, was cooled by water, and was subsequently cut by a pelletizer to obtain 140 parts of pellets of a resin composition. The aspect ratio A2 of conductive fibrous filler in the resin composition, measured as previously described, was 15. The degree of aspect ratio preservation A2/A1 between before and after mixing was 0.88.

The obtained resin composition was also used to evaluate various attributes as previously described. The results are shown in Table 1.

### (Example 2)

A resin composition was obtained in the same way as in Example 1 with the exception that in production of the resin composition, the conductive fibrous filler was changed to 66 parts of isotropic pitch-based carbon fiber (DONACARBO Milled S-246 produced by Osaka Gas Chemicals Co., Ltd.; fiber diameter: 13 µm; fiber length: 1 mm) having an aspect ratio A1 of 77. The aspect ratio A2 of conductive fibrous filler in the resin composition, measured as previously described, was 58. The degree of aspect ratio preservation A2/A1 between before and after mixing was 0.75.

The obtained resin composition was also used to evaluate various attributes as previously described. The results are shown in Table 1.

### (Example 3)

A resin composition was obtained in the same way as in Example 1 with the exception that in production of the resin composition, the conductive fibrous filler was changed to 42 parts of isotropic pitch-based carbon fiber (DONACARBO Milled S-246 produced by Osaka Gas Chemicals Co., Ltd.; fiber diameter: 13 µm; fiber length: 1 mm) having an aspect ratio A1 of 77. The aspect ratio A2 of conductive fibrous filler in the resin composition, measured as previously described, was 58. The degree of aspect ratio preservation A2/A1 between before and after mixing was 0.75.

The obtained resin composition was also used to evaluate various attributes as previously described. The results are shown in Table 1.

### (Example 4)

A resin composition was obtained in the same way as in Example 1 with the exception that in production of the resin composition, the conductive fibrous filler was changed to 42 parts of isotropic pitch-based carbon fiber (DONACARBO Chopped S-232 produced by Osaka Gas Chemicals Co., Ltd.; fiber diameter: 13 µm; fiber length: 5.5 mm) having an aspect ratio A1 of 423. The aspect ratio A2 of conductive fibrous filler in the resin composition, measured as previously described, was 360. The degree of aspect ratio preservation A2/A1 between before and after mixing was 0.85.

The obtained resin composition was also used to evaluate various attributes as previously described. The results are shown in Table 1.

### (Example 5)

A resin composition was obtained in the same way as in Example 1 with the exception that a hydrogenated norbornene-based ring-opened polymer produced as described below that was amorphous (amorphous hydrogenated norbornene-based ring-opened polymer) was used as a resin. The aspect ratio A2 of conductive fibrous filler in the resin composition, measured as previously described, was 15. The degree of aspect ratio preservation A2/A1 between before and after mixing was 0.88.

The obtained resin composition was also used to evaluate various attributes as previously described. The results are shown in Table 1.

### <Amorphous hydrogenated norbornene-based ring-opened polymer>

After loading 500 parts of dehydrated cyclohexane, 0.82 parts of 1-hexene, 0.15 parts of dibutyl ether, and 0.30 parts of triisobutylaluminum into a reactor at room temperature in a nitrogen atmosphere and performing mixing thereof, these materials were held at 45°C while continuously adding 76 parts of dicyclopentadiene (DCPD), 70 parts of 8-methyl-tetracyclo[4.4.0.1^{2,5}.1^{7,10}]dodec-3-ene (TCD), 54 parts of tetracyclo[7.4.0.0^{2,7}.1^{10,13}]trideca-2,4,6,11-tetraene (MTF), and 80 parts of tungsten hexachloride (0.7% toluene solution), concurrently to one another, over 2 hours to carry out polymerization. Next, 1.06 parts of butyl glycidyl ether and 0.52 parts of isopropyl alcohol were added to the polymerization solution so as to deactivate the polymerization catalyst and stop the polymerization reaction. Upon gas chromatographic analysis of the obtained reaction solution containing a ring-opened polymer, the polymerization conversion rate of monomers was 99.5%.

Next, 270 parts of cyclohexane was added to 100 parts of the obtained reaction solution containing the ring-opened polymer, 5 parts of nickel catalyst loaded on diatomaceous earth (nickel loading rate: 58 mass%; pore volume: 0.25 mL/g; specific surface area: 180 m²/g) was further added as a hydrogenation catalyst, the pressure was raised to 5 MPa with hydrogen, heating was performed to a temperature of 200°C under stirring, and then a reaction was carried out for 8 hours to yield a reaction solution containing a hydrogenated DCPD/TCD/MTF ring-opened copolymer. The hydrogenation catalyst was removed by filtration, and then cyclohexane serving as a solvent and other volatile components were removed from the solution at a temperature of 270°C and a pressure of 1 kPa or lower using a cylindrical evaporator (produced by Hitachi, Ltd.). Next, the hydrogenated product was extruded from an extruder in a molten state as strands, and was cooled and subsequently pelletized to obtain pellets. The hydrogenated ring-opened polymer that had been pelletized had an Mw of 34,000, a hydrogenation rate of 99% or more, and a glass-transition temperature of 135°C. Moreover, the hydrogenated ring-opened polymer was judged to be amorphous since a melting point was not observed.

### (Example 6)

A resin composition was obtained in the same way as in Example 1 with the exception that an addition polymer of a monomer having a norbornene structure (random copolymer of dicyclopentadiene derivative and ethylene; APEL^{®} 6013T (APEL is a registered trademark in Japan, other countries, or both) produced by Mitsui Chemicals, Inc.; amorphous) was used as a resin. The aspect ratio A2 of conductive fibrous filler in the resin composition, measured as previously described, was 15. The degree of aspect ratio preservation A2/A1 between before and after mixing was 0.88.

The obtained resin composition was also used to evaluate various attributes as previously described. The results are shown in Table 1.

### (Example 7)

A resin composition was obtained in the same way as in Example 4 with the exception that the amount of the conductive fibrous filler was changed to 200 parts. The aspect ratio A2 of conductive fibrous filler in the resin composition, measured as previously described, was 360. The degree of aspect ratio preservation A2/A1 between before and after mixing was 0.85.

The obtained resin composition was also used to evaluate various attributes as previously described. The results are shown in Table 1.

### (Example 8)

A resin composition was obtained in the same way as in Example 1 with the exception that in production of the resin composition, the conductive fibrous filler was changed to 42 parts of tin oxide fiber (FS-10P produced by Ishihara Sangyo Kaisha, Ltd.; fiber diameter: 0.01 µm to 0.02 µm; fiber length: 0.2 µm to 2 µm) having an aspect ratio A1 of 25. The aspect ratio A2 of conductive fibrous filler in the resin composition, measured as previously described, was 18. The degree of aspect ratio preservation A2/A1 between before and after mixing was 0.72.

The obtained resin composition was also used to evaluate various attributes as previously described. The results are shown in Table 1.

### (Example 9)

A resin composition was obtained in the same way as in Example 1 with the exception that a resin composition obtained by mixing 50 parts by mass of the crystalline hydrogenated norbornene-based ring-opened polymer produced in Example 1 and 50 parts by mass of the amorphous hydrogenated norbornene-based ring-opened polymer produced in Example 5 was used as a resin. This mixing was performed during compounding of the conductive fibrous filler. The aspect ratio A2 of conductive fibrous filler in the resin composition, measured as previously described, was 15. The degree of aspect ratio preservation A2/A1 between before and after mixing was 0.88.

The obtained resin composition was also used to evaluate various attributes as previously described. The results are shown in Table 1.

### (Comparative Example 1)

A resin composition was obtained in the same way as in Example 1 with the exception that in production of the resin composition, the conductive fibrous filler was not compounded, and 10 parts of titanium oxide whiskers (FTL-300 produced by Ishihara Sangyo Kaisha, Ltd.; fiber diameter: 0.27 µm; fiber length: 5.15 µm) having an aspect ratio of 191 were used in place thereof.

The obtained resin composition was used to evaluate various attributes as previously described. The results are shown in Table 1.

### (Comparative Example 2)

A resin composition was obtained in the same way as in Example 1 with the exception that in production of the resin composition, 42 parts of carbon fiber (Pyrofil^{®} Chopped Fiber TR06UB4E (Pyrofil is a registered trademark in Japan, other countries, or both) produced by Mitsubishi Rayon Co., Ltd.) having an aspect ratio of 857 was compounded in place of the conductive fibrous filler having a specific aspect ratio. The aspect ratio of conductive fibrous filler in the resin composition, measured as previously described, was 610.

The obtained resin composition was also used to evaluate various attributes as previously described. The results are shown in Table 1.

### (Comparative Example 3)

A resin composition was obtained in the same way as in Example 1 with the exception that in production of the resin composition, 13 parts of carbon fiber (EPU-LCL produced by Nihon Polymer Co., Ltd.; fiber diameter: 7.0 µm; fiber length: 6.0 mm) having an aspect ratio of 857 was compounded in place of the conductive fibrous filler having a specific aspect ratio. The aspect ratio of conductive fibrous filler in the resin composition, measured as previously described, was 620.

The obtained resin composition was also used to evaluate various attributes as previously described. The results are shown in Table 1.

**Table 1**

| | | | Examples | | | | | | | | | Comparative examples | | |
|---|---|---|---|---|---|---|---|---|---|---|---|---|---|---|
| | | | 1 | 2 | 3 | 4 | 5 | 6 | 7 | 8 | 9 | 1 | 2 | 3 |
| Resin | Amorphous norbornene-based ring-opened polymer | | - | - | - | - | 100 | - | - | - | 50 | - | - | - |
| | Crystalline norbornene-based ring-opened polymer | | 100 | 100 | 100 | 100 | - | - | 100 | 100 | 50 | 100 | 100 | 100 |
| | Amorphous norbornene-based addition polymer | | - | - | - | - | - | 100 | - | - | - | - | - | - |
| Conductive fibrous filler | Carbon fiber | Aspect ratio: 15 (pre-mixing: 17) | 42 | - | - | - | 42 | 42 | - | - | 42 | - | - | - |
| | | Aspect ratio: 58 (pre-mixing: 77) | - | 66 | 42 | - | - | - | - | - | - | - | - | - |
| | | Aspect ratio: 360 (pre-mixing: 423) | - | - | - | 42 | - | - | 200 | - | - | - | - | - |
| | | Aspect ratio: 610 | - | - | - | - | - | - | - | - | - | - | 42 | - |
| | | Aspect ratio: 620 | - | - | - | - | - | - | - | - | - | - | - | 13 |
| | SnO₂ fiber | Aspect ratio: 18 (pre-mixing: 25) | - | - | - | - | - | - | - | 42 | - | - | - | - |
| Other | | | - | - | - | - | - | - | - | - | - | Titanium oxide whiskers: 10 parts | - | - |
| Evaluation | Amount of particles (particles/mL) | | 7000 | 7500 | 7200 | 9000 | 7000 | 8000 | 9500 | 7000 | 7000 | 9000 | 30000 | 25000 |
| | Surface resistivity (Ω) | | 3 × 10⁷ | 1 × 10⁵ | 4 × 10⁷ | 4 × 10⁷ | 6 × 10⁷ | 6 × 10⁷ | 2 × 10³ | 5 × 10⁷ | 5 × 10⁷ | 4 × 10¹⁴ | 4×10⁶ | 7 × 10⁸ |
| | Amount of outgas (ppm) | | 30 | 25 | 30 | 30 | 30 | 40 | 20 | 30 | 30 | 30 | 70 | 50 |
| | Strength (MPa) | | 120 | 140 | 110 | 140 | 100 | 100 | 180 | 120 | 110 | 70 | 120 | 90 |

It can be seen from Table 1 that the resin compositions according to Examples 1 to 9, which each contained a specific resin and a conductive fibrous filler having an aspect ratio of not less than 5 and not more than 500, enabled a balance of high levels of electrical conductivity and cleanliness in an obtained shaped item.

In contrast, it can be seen that the electrical conductivity of an obtained shaped item could not be increased in Comparative Example 1 in which a specific conductive fibrous filler was not included and that a large amount of particles detached from an obtained shaped item and cleanliness of the shaped item could not be increased in Comparative Examples 2 and 3 in which a conductive fibrous filler having an aspect ratio exceeding the range according to the present disclosure was compounded.

### INDUSTRIAL APPLICABILITY

According to the present disclosure, it is possible to provide a resin composition that enables a balance of high levels of electrical conductivity and cleanliness in an obtained shaped item and a method of producing this resin composition.

Moreover, according to the present disclosure, it is possible to provide a shaping material, a packaging container, and a semiconductor container that can display a balance of high levels of electrical conductivity and cleanliness.

## Claims

1. A resin composition comprising:
a resin including one or more among a norbornene-based polymer, a monocyclic cycloolefin-based polymer, a cyclic conjugated diene-based polymer, a vinyl alicyclic hydrocarbon polymer, and hydrogenated products thereof; and
a conductive fibrous filler having an aspect ratio of not less than 5 and not more than 500.

2. The resin composition according to claim 1, wherein an amount of the conductive fibrous filler is not less than 30 parts by mass and not more than 240 parts by mass relative to 100 parts by mass of the resin.

3. The resin composition according to claim 1 or 2, wherein the resin includes a crystalline resin.

4. The resin composition according to any one of claims 1 to 3, wherein the resin includes a ring-opened polymer of a monomer having a norbornene structure or a hydrogenated product thereof.

5. A shaping material comprising the resin composition according to any one of claims 1 to 4.

6. A packaging container obtained through shaping of the resin composition according to any one of claims 1 to 4.

7. A semiconductor container obtained through shaping of the resin composition according to any one of claims 1 to 4.

8. A method of producing the resin composition according to any one of claims 1 to 4, comprising a mixing step of mixing the resin and a conductive fibrous filler ingredient having an aspect ratio of not less than 17 and not more than 500 to obtain a mixture of the resin and a conductive fibrous filler having an aspect ratio of not less than 5 and not more than 500.
